# EUROPÄISCHE PATENTANMELDUNG

(11) **EP 0 766 355 A1**
(43) Veröffentlichungstag der Anmeldung: **02.04.1997**
(21) Anmeldenummer: 96114169.4
(22) Anmeldetag: 04.09.1996
(51) Int. Cl.: H01S 3/025, H01L 33/00

(54) **Verfahren zur Montage eines Halbleiterlaser-Bauelements**

(30) Priorität: 29.09.1995 DE 19536434
(71) Anmelder: SIEMENS AKTIENGESELLSCHAFT, 80333 München (DE)
(72) Erfinder: Späth, Werner, Dipl.-Phys., 83607 Holzkirchen (DE)

(57) **Zusammenfassung**

Bei dem erfindungsgemäßen Verfahren zur Herstellung eines Halbleiterlaser-Bauelement s wird ein Halbleiterkörper (1) auf einer Trägerplatte (3) befestigt. Die Trägerplatte (3) besteht aus einem Material, das denselben thermischen Ausdehnungskoeffizienten aufweist, wie das Material des Halbleiterkörpers (1). Der Halbleiterkörper (1) wird mittels einer Verbindungsschicht (4) aus einem elektrisch und thermisch leitenden Material auf der Trägerplatte (3) befestigt. Im Anschluß daran werden auf den Halbleiterkörper (1) Deckschichten, z. B. Spiegelschichten (12, 13) aufgebracht. Diese Verfahrensabfolge hat den Vorteil, daß eine Verunreinigung der Kontaktflächen des Halbleiterkörpers (1) mit Deckschichtmaterial verhindert werden kann.

## Beschreibung

Die Erfindung betrifft ein Verfahren zur Herstellung eines Halbleiterlaser-Bauelements, bei dem ein Halbleiterkörper, der auf mindestens einem Teilbereich seiner Oberfläche eine Deckschicht aufweist, auf einer Trägerplatte befestigt wird.

Um Halbleiterlaser-Bauelemente, insbesonderer Hochleistungs-Halbleiterlaser-Bauelemente, vor einer Schädigung durch Überhitzung zu bewahren, werden diese häufig auf Kühlkörper montiert. Diese Kühlkörper sind so gestaltet, daß eine schnelle Abgabe der im Halbleiterkörper erzeugten Verlustwärme an die Umgebung möglich ist.

Aus der deutschen Offenlegungsschrift DE 43 15 580 ist eine Anordnung aus Laserdiodenchips und einer sogenannten Mikrokanalwärmesenke bekannt. Beim Herstellen dieser Anordnung werden die Laserdioden-Chips nach ihrer Fertigstellung auf eine Deckplatte einer Mikrokanalwärmesenke (MKWS) aufgelötet, die aus mehreren Cu-Blechen besteht. Aufgrund der unterschiedlichen thermischen Ausdehnungskoeffizienten von Kupfer und Halbleitermaterial wird dazu ein plastisch verformbares Lotmaterial verwendet.

Die Verbindung zwischen Laserdiodenchip und Deckplatte muß hinsichtlich ihrer thermischen, elektrischen und mechanischen Eigenschaften möglichst über den gesamten Verbindungsbereich eine hohe Gleichmäßigkeit aufweisen, damit ein homogener Strom- und Wärmeübergang zwischen Halbleiterkörper und Grundplatte stattfinden kann. Inhomogene thermische und/oder elektrische Eigenschaften führen im Laserdiodenchip zu inhomogenen Wärme- und/oder Stromverteilungen, die beispielsweise die Alterung beschleunigen und im Extremfall die Zerstörung des Laserdiodenchips auslösen können.

Das Erfüllen der oben genannten Anforderungen ist insbesondere dann sehr schwierig, wenn, wie es beispielsweise häufig bei Laserdiodenchips der Fall ist, die Oberfläche des Halbleiterkörpers mit einem Material verunreinigt ist, so daß das Lot die Oberfläche nur teilweise oder überhaupt nicht benetzt. Bei Halbleiterkörpern von Laserdiodenchips ist die Oberfläche meist mit Spiegelmaterial, wie beispielsweise Al₂O₃, SiO₂, Si, SiC und/oder Si₃N₄, kontaminiert, das unmittelbar nach der Fertigstellung des Halbleiterkörpers beispielsweise auf dessen Seitenflächen aufgebracht wird. Diese Spiegelschichten bilden den optischen Resonators des Lasers. Bei dieser Vorgehensweise ist es nahezu unvermeidbar bzw. nur mit sehr großem verfahrenstechnischen Aufwand möglich, eine Verunreinigung der Kontaktflächen des Halbleiterkörpers zu verhindern. Mit 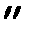 Kontaktflächen" sind diejenigen Teilbereiche der Oberfläche des Halbleiterkörpers gemeint, auf die Kontaktplatten, wie beispielsweise die Grundplatte, oder Kontaktmetallisierungen aufgebracht werden.

Bisher wird dieses Problem oftmals dadurch gelöst, daß die Kontaktfläche(n) des Halbleiterkörpers nach dem Spiegelbeschichten gereinigt werden. Eine solche Reinigung ist jedoch erstens mit einem zusätzlichen Verfahrensschritt und zweitens mit einer erhöhten Bruchgefahr für den Halbleiterkörper verbunden. Der zweitgenannte Nachteil gilt insbesondere für Halbleiterkörper aus III-V-Halbleitermaterial wie z. B. GaAs, AlGaAs oder InAlGaAs.

Der Erfindung liegt daher die Aufgabe zugrunde, ein Verfahren der eingangs genannten Art zu entwickeln, bei dem eine Verunreinigung der Kontaktfläche(n) des Halbleiterkörpers mit schlecht benetzbarem Material vermieden wird.

Diese Aufgabe wird durch ein Verfahren mit den Merkmalen des Anspruches 1 gelöst.

Erfindungsgemäß ist vorgesehen, daß die Deckschicht nach dem Befestigen des Halbleiterkörpers auf die Trägerplatte aufgebracht wird.

Bei einer bevorzugten Weiterbildung des erfindungsgemäßen Verfahrens besteht die Trägerplatte aus einem Material, das sowohl eine gute thermische als auch eine gute elektrische Leitfähigkeit aufweist. Dies hat den besonderen Vorteil, daß die Trägerplatte gleichzeitig als elektrischer Anschluß und/oder als thermischer Anschluß genutzt werden kann.

Bei einer vorteilhaften Ausführungsform des erfindungsgemäßen Verfahrens wird für die Trägerplatte ein Material verwendet, das einen ähnlichen thermischen Ausdehnungskoeffizienten hat wie das Halbleitermaterial des Halbleiterkörpers. Dadurch können insbesondere mechanische Spannungen im Halbleiterlaser-Bauelement verringert werden.

Bei einer besonders bevorzugten Ausführungsform des erfindungsgemäßen Verfahrens ist die Deckschicht eine Spiegelschicht und wird der Halbleiterkörper so auf der Trägerplatte positioniert, daß zumindest eine Seitenfläche des Halbleiterkörpers mit einer Seitenfläche der Trägerplatte bündig abschließt. Auf diese Weise kann zumindest auf dieser Seitenfläche eine Deckschicht mit einer sehr homogenen Dicke hergestellt werden.

Bei einer weiterhin bevorzugten Weiterbildung des erfindungsgemäßen Verfahrens wird an zwei gegenüberliegenden Seitenflächen des Halbleiterkörpers je eine Spiegelschicht aufgebracht. Diese Spiegelschichten bilden beispielsweise den Resonator des Halbleiterlaser-Bauelements.

Eine vorteilhafte Weiterbildung des erfindungsgemäßen Verfahrens besteht darin, daß der Halbleiterkörper mittels eines Hartlotes auf der Trägerplatte befestigt ist. Damit kann insbesondere eine sehr stabile und dauerhafte Verbindung sichergestellt werden.

Bei einer besonders bevorzugte Ausführungsform des erfindungsgemäßen Verfahrens wird der Halbleiterkörper so auf der Trägerplatte positioniert, daß zumindest die Seitenfläche des Halbleiterkörpers, aus der ein Laserstrahl aus dem Halbleiterkörper austritt, mit einer Seitenfläche der Trägerplatte bündig abschließt. Dies trägt vorteilhafterweise dazu bei, die Störungen des Laserstrahles nach dem Austritt aus dem Halbleiterkörper zu minimieren.

Eine vorteilhafte Ausführungsform der Trägerplatte besteht darin, daß mindestens eine Stirnfläche, bevorzugt diejenige, welche an eine Laserstrahl-Austrittsfläche des Halbleiterkörpers angrenzt, derart abgeschrägt ist, daß sie mit der Laserstrahl-Austrittsfläche einen Winkel zwischen 90° und 180° einschließt. Dadurch kann vorteilhafterweise eine maximale Wärmeableitung bei gleichzeitig minimaler Störung des Laserstrahles nach Austritt aus dem Halbleitkörper erreicht werden.

Weiterhin ist vorteilhaft, wenn die Deckschicht derart ausgebildet ist, daß sie sich mit der Trägerplatte überlappt, d. h. daß die Deckschicht auch einen Teil der Trägerplatte bedeckt. Dies hat den besonderen Vorteil, daß bekanntlich besonders im Randbereich auftretende Inhomogenitäten der Deckschicht, nicht auf dem Halbleiterkörper zu liegen kommen.

Weitere vorteilhafte Weiterbildungen der Erfindung sind Gegenstand von Unteransprüchen und ergeben sich aus der nachfolgenden Beschreibung von Ausführungsbeispielen.

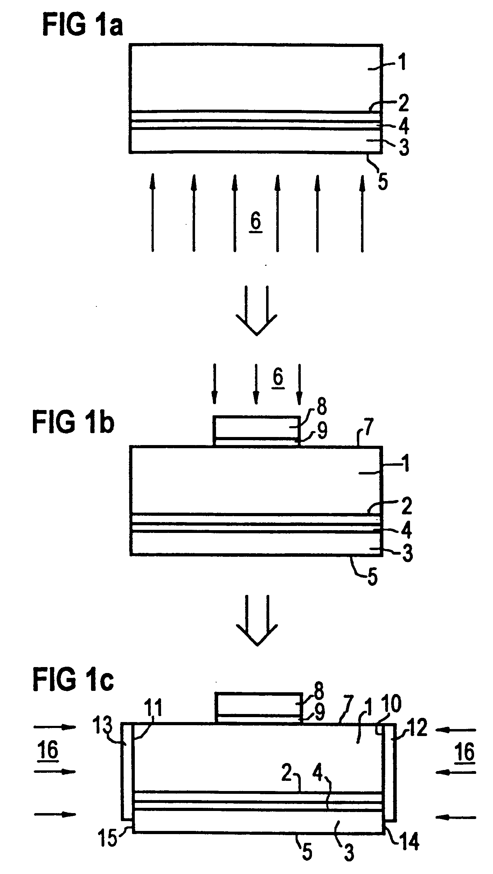

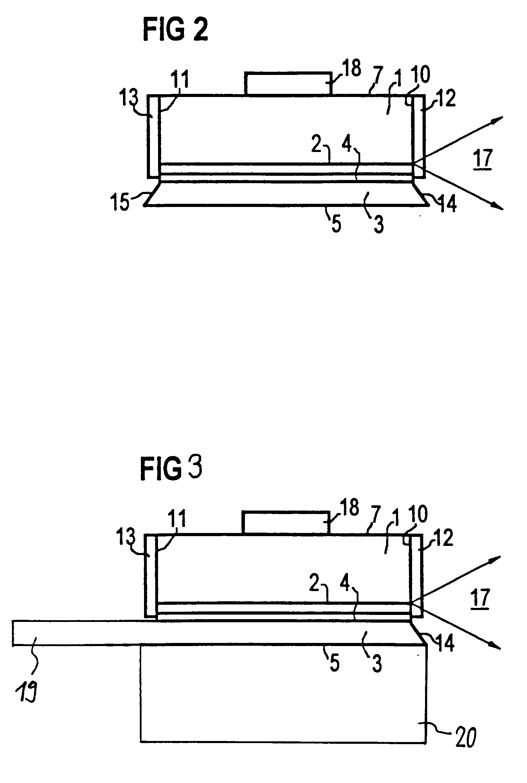

Die Erfindung wird anhand zweier Ausführungsbeispiele in Verbindung mit den Figuren 1 und 2 näher erläutert. Es zeigen
Figuren 1a bis 1c eine schematische Darstellung eines erfindungsgemäßen Verfahrens,
Figur 2 eine schematische Darstellung eines nach einem erfindungsgemäßen Verfahren hergestellten Halbleiterlaser-Bauelements und
Figur 3 eine schematische Darstellung eines weiteren nach einem erfindungsgemäßen Verfahren hergestellten Halbleiterlaser-Bauelements.

In den Figuren sind gleiche oder gleichwirkende Bestandteile jeweils mit demselben Bezugszeichen versehen.

In den Figuren 1a bis 1c ist die Herstellung einer seitlich emittierenden Laserdiode nach dem erfindungsgemäßen Verfahren schematisch dargestellt. Als erster Schritt wird ein Halbleiterkörper 1 mit einem laseraktiven pn-Übergang 2, beispielsweise bestehend aus GaAs, AlGaAs und/oder InAlGaAs auf einer Trägerplatte 3 befestigt (Fig. 1a). Die Trägerplatte 3, deren Dicke zwischen 20 µm und 100 µm liegt, besteht aus Molybdän oder aus einem anderen Material, das einen ähnlichen thermischen Ausdehnungskoeffizienten wie das Material des Halbleiterkörpers 1, eine gute thermische und eine gute elektrische Leitfähigkeit aufweist. Als Verbindungsmittel 4 zwischen dem Halbleiterkörper 1 und der Trägerplatte 3 wird ein Hartlot verwendet, beispielsweise eine AuSn-Legierung. Denkbar wäre jedoch auch die Verwendung eines elektrisch und thermisch leitenden Klebstoffes. Das Verbindungsmittel 4 wird vor der Befestigung des Halbleiterkörpers 1 beispielsweise mittels Aufdampfen, Sputtern oder Eintauchen in verflüssigtes Verbindungsmittel auf den Halbleiterkörper 1 oder auf die Trägerplatte 3 aufgebracht. Die Schichtdicke liegt zwischen 1 µm und 2 µm. Eine eventuell erforderliche Strukturierung des Verbindungsmittels 4 kann mittels Maskentechnik oder Photolithographie erfolgen. Zur Verbesserung der Löteigenschaften von Trägerplatte 3 und Halbleiterkörper 1 und/oder der Beständigkeit der Lötverbindung kann auf der Trägerplatte 3 und/oder auf den Halbleiterkörper 1 ein elektrisch leitender Haftvermittler, beispielsweise eine TiPt-Au-Schichtenfolge, eine TiPd-Au- Schichtenfolge oder ein anderer geeigneter Werkstoff, aufgebracht sein. Die Au-Schicht, deren Dicke beispielsweise ca. 1 µm beträgt, verbessert die Benetzung zwischen dem Lot und Pt oder Pd.

Das Verbinden des Halbleiterkörpers 1 mit der Trägerplatte 3 kann beispielsweise mittels Bestrahlung der Unterseite 5 der Trägerplatte 3 mit Laserstrahlung 6 erfolgen. Dieser Vorgang ist in Figur 1c durch die Pfeile 16 angedeutet und wird im weiteren kurz mit Laserlöten bezeichnet. Der Fachmann kann jedoch auch jedes andere ihm als geeignet erscheinende Lötverfahren einsetzen.

Zum Laserlöten eignet sich bevorzugt ein Hochleistungs-Halbleiterlaser. Mit einem solchen Laser läßt sich nämlich die Löttemperatur und die Dauer des Lötvorganges auf einfache Weise genau einstellen lassen. Vorteilhaft wirkt sich diesbezüglich die geringe Dicke der Trägerplatte 3 aus. Aufgrund der damit verbundenen geringen Wärmeaufnahme kann ein gewünschtes Temperatur-Zeit-Profil sehr exakt realisiert werden. Das Temperatur-Zeit-Profil ist bekanntlich von wesentlicher Bedeutung für das Herstellen von homogenen und reproduzierbaren Lötstellen.

Als nächster Schritt wird auf die Oberseite 7 des Halbleiterkörpers 1 eine Kontaktplatte 8 aufgebracht (Fig. 1b). Diese besteht z. B. aus demselben Material wie die Trägerplatte 3 und ist ebenfalls mittels Laserlöten befestigt. Als Verbindungsmittel 9 wird wiederum ein Hartlot eingesetzt, z. B. Au oder eine AuSn-Legierung.

Anstelle der Kontaktplatte 8 kann eine Kontaktmetallisierung, beispielseise aus Au, Al, einer Au- oder einer Al-Basislegierung auf den Halbleiterkörper 1 aufgebracht werden. Bei Bedarf kann die Kontaktplatte 8 bzw. die Kontaktmetallisierung die gesamte Oberseite 7 des Halbleiterkörpers 1 bedecken. Ebenso können mehrere Kontaktplatten 8 oder Kontaktmetallisierungen auf die Oberseite 7 des Halbleiterkörpers 1 aufgebracht werden.

Im Anschluß an das Befestigen der Kontaktplatte 8 auf der Oberseite 7 des Halbleiterkörpers 1 wird beispielsweise mittels Aufdampfen oder Sputtern auf die Endflächen 10, 11 des Halbleiterkörpers 1 je eine Spiegelschicht 12, 13 aufgebracht (Fig. 1c). Diese bestehen beispielsweise aus Al₂O₃, SiO₂, Si, SiC und/oder Si₃N₄ oder aus einem anderen geeigneten Material, das strahlungsdurchlässig ist und die Halbleiteroberfläche (Halbleiterspiegel) vor Oxidation u. Korrosion schützt. Der Aufdampf- bzw. Sputtervorgang ist in Figur 1c durch die Pfeile 16 angedeutet. Die beiden Spiegelschichten 12, 13 bilden den optischen Resonator der Laserdiode.

Bei der in Figur 1c dargestellten Laserdiode entspricht die Breite der Trägerplatte 3 genau dem Abstand zwischen den beiden Endflächen 10, 11 des Halbleiterkörpers 1 und die beiden Endflächen 10, 11 des Halbleiterkörpers 1 schließen bündig mit den beiden Seitenflächen 14, 15 der Trägerplatte 3 ab. Dieser Idealfall ist jedoch aufgrund unvermeidbarer Fertigungstoleranzen bei der Herstellung des Halbleiterkörpers 1 und der Trägerplatte 3 sowie aufgrund von Toleranzen bei der Positionierung des Halbleiterkörpers 1 auf der Trägerplatte 3 nicht sicher reproduzierbar.

Hinsichtlich der Abmessungen von Halbleiterkörper 1 und Trägerplatte 3 müssen folgende Mindestbedingungen erfüllt sein:
a) Ein Überstand der Trägerplatte 3 über die Endflächen 10, 11 des Halbleiterkörpers 1 hinaus muß so bemessen sein, daß dadurch keine Abschattung der Endflächen 10, 11 beim Spiegelbeschichten verursacht wird. Eine Inhomogenität der Spiegeloberflächen würde zu einer Störung der im Halbleiterkörper 1 erzeugten Laserstrahlung führen.
b) Auf der Seite der Strahlaustrittsfläche des Halbleiterkörpers 1 darf die Trägerplatte 3 nur so weit über den Halbleiterkörper 1 hinausragen, daß der Laserstrahl nicht durch Reflexion auf der Trägerplatte 3 gestört wird. Die Strahlaustrittsfläche ist diejenige Seitenfläche, durch welche der Laserstrahl aus dem Halbleiterkörper 1 austritt.
c) Gleichzeitig zu den beiden oben genannten Bedingungen muß die Trägerplatte 1 eine maximale Wärmeableitung gewährleisten. Daher ist ein möglichst großer wirksamer Querschnitt der Trägerplatte 1 anzustreben.

Ein Halbleiterlaser-Bauelement , das nach dem oben beschriebenen erfindungsgemäßen Verfahren hergestellt wird und bei dem der wirksame Querschnitt der Trägerplatte 3 gegenüber dem in Figur 1c dargstellten Halbleiterlaser-Bauelement vergrößert ist, bei gleichzeitiger Erfüllung der Bedingungen a) bis c), ist in Figur 2 schmatisch dargestellt. Der Unterschied zu dem Halbleiterlaser-Bauelement nach Figur 1c besteht im wesentlichen darin, daß die an die Endflächen 10, 11 des Halbleiterkörpers 1 angrenzenden Seitenflächen 14, 15 der Trägerplatte 3 abgeschrägt sind. Der Winkel zwischen den Seitenfläche 14, 15 und der Unterseite 16 der Trägerplatte 3 beträgt beispielsweise 45°. Die Größe des Winkels ist abhängig von der Divergenz des aus dem Halbeiterkörper 1 austretenden Laserstrahles 17 und kann zwischen 0° und 90° liegen. Anstelle der Kontaktplatte 8 ist hier eine Kontaktmetallisierung 18, beispielsweise aus Al, auf den Halbleiterkörper 1 aufgebracht. Der Vorteil der Abschrägung der Trägerplatte 3 besteht unter anderem darin, daß damit eine erhöhte Wärmeableitung erreicht werden kann.

Das in Figur 3 schematisch dargestellte Halbleiterlaser-Bauelement weist im Unterschied zu dem oben beschriebenen Halbleiterlaser-Bauelement beispielhaft eine Trägerplatte 3 auf, an der eine Anschlußfahne 19 zum elektrischen Anschließen des Halbleiterkörpers 1 ausgebildet ist. Dadurch kann vorteilhafterweise die Trägerplatte 3 gleichzeitig als als elektrischer Anschluß verwendet werden. Weiterhin ist hier an die Trägerplatte 3 beispielhaft eine Wärmesenke 20 thermisch leitend angeschlossen.

Die Tatsache, daß das Material der Trägerplatte 3 einen ähnlichen thermischen Ausdehnungskoeffiezienten wie das Halbleitermaterial des Halbleiterkörpers 1 aufweist, erlaubt es, wie in Figur 1c bereits dargestellt, die Spiegelschichten 12, 13 derart aufzubringen, daß sie nicht nur die Endflächen 10, 11 sondern mindestens auch Teilbereiche der Seitenflächen 14, 15 der Trägerplatte 3 bedecken. Das Herstellen von Spiegelschichten 12, 13, die zumindest im Bereich des laseraktiven pn-Überganges 2 eine gleichmäßige Dicke aufweisen, ist dadurch deutlich vereinfacht.

Bei Verwenden eines Trägerplattenmaterials, dessen thermischer Ausdehnungskoeffizient sich deutlich von dem des Halbleitermaterials unterscheidet, wäre eine solche Überlappung der Spiegelschichten 12, 13 mit der Trägerplatte 3 nicht zulässig. Bei Erwärmung des Halbleiterlaser-Bauelements würden dann nämlich in den Spiegelschichten 12, 13 aufgrund von unterschiedlichen thermischen Ausdehnungen erhebliche mechanische Spannungen entstehen, die im Extremfall zum Bruch der Spiegelschichten 12, 13 und damit zur Zerstörung der Laserdiode führen können.

Das erfindungsgemäße Verfahren hat den weiteren Vorteil, daß das Entfernen von Verunreinigungen auf der Unterseite 5 einer stabilen Trägerplatte 3 wesentlich einfacher und unkritischer ist, als das Entfernen von Verunreinigungen auf dem Halbleiterkörper 1. Viele Halbleitermaterialien, insbesondere GaAs, AlGaAs und InAlGaAs, sind nämlich äußerst empfindlich gegenüber mechanischer Beanspruchung. Ebenso kann vor einem Besputtern das Halbleitermaterial z. B. mittels eines Photolackes abgedeckt werden, um Verunreinigungen zu vermeiden.

Die in den Figuren 1c, 2 und 3 schematisch dargestellten Halbleiterlaser-Bauelemente können im Anschluß an die oben beschriebenen und möglichen weiteren Verfahrensschritte in einfacher Weise auf einem Kühlkörper montiert werden. Als Kühlkörper bietet sich beispielsweise eine Platte aus Diamant oder eine Mikrokanalwärmesenke aus Kupfer, Si oder Kunststoff an. Derartige Kühlkörper sind dem durchschnittlichen Fachmann bekannt und können je nach Material mittels Kleben, Löten oder Schweißen an der Trägerplatte 3 befestigt werden. Zur zusätzlichen Kühlung kann auch an die Kontaktplatte 8 ein Kühlkörper angebracht werden.

### Bezugszeichenliste

- 1: Halbleiterkörper
- 2: laseraktiver pn-Übergang
- 3: Trägerplatte
- 4: Verbindungsmittel
- 5: Unterseite der Trägerplatte
- 6: Laserstrahlung
- 7: Oberseite des Halbleiterkörpers
- 8: Kontaktplatte
- 9: Verbindungsmittel
- 10,11: Endflächen
- 12,13: Spiegelschicht
- 14,15: Seitenflächen
- 16: Aufdampf- bzw.Sputtervorgang
- 17: Laserstrahl
- 18: Kontaktmetallisierung
- 19: Anschlußfahne
- 20: Wärmesenke

## Patentansprüche

1. Verfahren zur Herstellung eines Halbleiterlaser-Bauelements, bei dem ein Halbleiterkörper (1), der auf mindestens einem Teilbereich seiner Oberfläche eine Deckschicht (12, 13) aufweist, auf einer Trägerplatte (3) befestigt wird, **dadurch gekennzeichnet**, daß die Deckschicht (12, 13) nach dem Befestigen des Halbleiterkörpers (1) auf die Trägerplatte (3) aufgebracht wird.

2. Verfahren nach Anspruch 1, **dadurch gekennzeichnet**, daß die Trägerplatte (3) aus einem Material besteht, das sowohl eine gute thermische als auch eine gute elektrische Leitfähigkeit aufweist.

3. Verfahren nach Anspruch 1 oder 2, **dadurch gekennzeichnet**, daß für die Trägerplatte (3) ein Material verwendet wird, das einen ähnlichen thermischen Ausdehnungskoeffizienten hat wie das Halbleitermaterial des Halbleiterkörpers (1).

4. Verfahren nach einem der Ansprüche 1 bis 3, **dadurch gekennzeichnet**, daß der Halbleiterkörper (1) so auf der Trägerplatte (3) positioniert wird, daß zumindest eine Seitenfläche (10, 11) des Halbleiterkörpers (1), mit einer Seitenfläche (14, 15) der Trägerplatte (3) bündig abschließt.

5. Verfahren nach einem der Ansprüche 1 bis 4, **dadurch gekennzeichnet**, daß eine Trägerplatte (3) aus Mo gewählt wird.

6. Verfahren nach einem der Ansprüche 1 bis 5, **dadurch gekennzeichnet**, daß zum Befestigen des Halbleiterkörpers (1) auf der Trägerplatte (3) ein Hartlot (4) verwendet wird.

7. Verfahren nach einem der Ansprüche 1 bis 6, **dadurch gekennzeichnet**, daß die Deckschicht (12,13) eine Spiegelschicht ist und an zwei gegenüberliegenden Seitenflächen (10,11) auf den Halbleiterkörper (1) aufgebracht wird.

8. Verfahren nach Anspruch 7, **dadurch gekennzeichnet**, daß der Halbleiterkörper (1) so auf der Trägerplatte (3) positioniert wird, daß zumindest die Seitenfläche (10 oder 11) des Halbleiterkörpers (1), aus der ein Laserstrahl (17) aus dem Halbleiterkörper (1) austritt, mit einer Seitenfläche (14, 15) der Trägerplatte (3) bündig abschließt.

9. Verfahren nach einem der Ansprüche 1 bis 8, **dadurch gekennzeichnet**, daß die Trägerplatte (3) derart gewählt wird, daß die Breite ihrer Oberseite (18) in etwa dem Abstand von zwei gegenüberliegenden Seitenflächen (10, 11) des Halbleiterkörpers (1) entspricht.

10. Verfahren nach einem der Ansprüche 1 bis 9, **dadurch gekennzeichnet**, daß die Trägerplatte (3) so gewählt wird, daß mindestens eine ihrer Seitenflächen (14, 15) abgeschrägt ist.

11. Verfahren nach einem der Ansprüche 1 bis 10, **dadurch gekennzeichnet**, daß zumindest auf einen Teil mindestens einer der Seitenflächen (14, 15) der Trägerplatte (3) mindestens ein Teil einer Spiegelschicht (12, 13) aufgebracht wird.
